# EUROPÄISCHE PATENTSCHRIFT

(11) **EP 1 909 369 B1**
(45) Veröffentlichungstag und Bekanntmachung des Hinweises auf die Patenterteilung: **20.05.2020**
(21) Anmeldenummer: 07405299.4
(22) Anmeldetag: 04.10.2007
(51) Int. Cl.: H02H 7/122, G01R 27/18

(54) **Schaltungsanordnung und Verfahren zur Isolationsüberwachung für im Betrieb befindliche Umrichteranwendungen**
Switching assembly and method for insulation monitoring for converter applications in operation
Agencement de commutation et procédé de surveillance d'isolation pour des applications de convertisseur en fonctionnement

(30) Priorität: 06.10.2006 CH 16022006
(43) Veröffentlichungstag der Anmeldung: 09.04.2008
(73) Patentinhaber: Schmidhauser AG, 8590 Romanshorn (CH)
(72) Erfinder: Itten, Alex, 8590 Romanshorn (CH); Thür, Peter, 8500 Frauenfeld (CH)
(74) Vertreter: Patentanwälte Ruff, Wilhelm, Beier, Dauster & Partner mbB

(56) Entgegenhaltungen:
- EP-A2- 1 336 528
- JP-A- 2000 116 144
- US-A- 5 686 839

## Beschreibung

Die Erfindung bezieht sich auf das Gebiet der Leistungselektronik. Sie bezieht sich insbesondere auf ein Verfahren und eine Vorrichtung zur Isolationsüberwachung für Umrichteranwendungen.

### STAND DER TECHNIK

In einem IT-System (frz. Isole Terre) oder IT-Netz sind leitfähige Gehäuse der Einrichtungen geerdet, aber nicht der Sternpunkt eines speisenden Transformators. Bei einem ersten Isolationsfehler zwischen einem der Leiter des Netzes und dem Gehäuse oder der Erde herrscht somit (bei kleinen Netzen) keine gefährliche Berührungsspannung. Eine Isolationsüberwachung muss diesen ersten Fehler detektieren, bevor ein zweiter, potentiell gefährlicher Fehler auftritt.

Bei IT Netzen mit elektrischen (getakteten) Antrieben entstehen durch die Umlagerung von Ladungsträgern in Kabel und Motorkapazitäten Fehlerströme, die sich ähnlich wie Fehlerströme durch Isolationsdefekte verhalten. Dadurch lassen sich herkömmliche Isolationsprüfgeräte stören, was zu irreführenden Fehlermeldung über den Zustand der Isolationen führt. Die Einstellung der Warn- und Fehlergrenzen wird durch die Abhängigkeit dieser kapazitiven Fehlerströme von der Anzahl der Antriebe, deren momentanen Betriebszustände und von der Verlegungsart der Kabel stark erschwert und teilweise verunmöglicht. Erschwerend kommt hinzu, dass diese kapazitiven Fehlerströme sich durch die Alterung der Installation, die Verunreinigung und durch Feuchtigkeit verändern können, so dass auch einmal optimal eingestellte Wamungs- und Fehlergrenzen später nachgestellt werden müssen, um irreführende Fehlermeldungen zu vermeiden.

Isolationsüberwachungsgeräte müssen ihre eigene Funktionsweise periodisch selbst überwachen. In der Regel werden dazu zusätzlich Schaltungsteile eingebaut, die im Fehlerfall selbst zu einem einen Isolationsverlust führen können, was die Ausfallrate des Gesamtsystems erhöht.

Isolationsdefekte können überall im System auftreten und sind daher auch schwer zu lokalisieren. Dies führt in komplexen Anlagen zu sehr hohen Fehlerbereinigungskosten, indem z.B. wiederholt die falschen Komponenten ausgetauscht werden, weil die genaue Ursache im Feld nicht bestimmt werden kann. Ebenso kann bei Wartungsarbeiten aufgrund der sporadisch auftretenden Erhöhung und Absenkung der kapazitiven Fehlerströme ein tatsächlich vorhandener Isolationsschaden nicht oder zu spät erkannt werden, weil die Fehlerdiagnose nur sehr ungenau durchgeführt werden kann.

In DE 42 03 299 A1 ist eine Anordnung vorgestellt, die einen Teil der in elektrischen Antrieben (Umrichtereinrichtungen) vorhandenen Messkreis zur Messung der Gleichspannung im Zwischenkreis zur Überwachung der Isolation verwendet. Dieses Verfahren wird da für Einsätze in druckfest gekapselten Gehäusen verwendet, wobei die Überwachungsgrenzwerte durch Einstellung von Widerstandswerten und die Unterdrückung von den durch die Schalthandlung der Antriebe erzeugten kapazitiven Fehlerströme durch Tiefpassfilterung erreicht wird. Dieses Verfahren hat die in der Einleitung erwähnten Nachteile und kann den Ort des Isolationsfehlers nicht bestimmen.

Die DE 43 39 946 A1 und die DE 101 06 200 C1 zeigen Isolationsüberwachungen durch Einspeisen einer Messspannung über eine ohmsche Messankopplung. Die Messspannung wird durch eine besondere Erzeugerschaltung erzeugt.

DE 696 24 409 T2 zeigt eine Isolationsüberwachung bei Elektrofahrzeugen, bei welcher eine Mess-Wechselspannung kapazitiv in das Netz eingespeist und der so eingespeiste Strom gemessen wird.

DE 195 03 749 C1 beschreibt eine Messbrücke zur Bestimmung einer Asymmetrie im Bordnetz eines Elektrofahrzeuges, welche eine Verschiebung der positiven oder der negativen Speisespannung detektiert.

EP 0 490 388 offenbart einen Fehlerstromdetektor für einen Umrichter, welcher vermittelst Shunt-Widerständen den Strom durch jede der Halbbrücken misst und einen Erdfehler signalisiert, falls ein Überstrom auftritt und gleichzeitig alle Schalter der oberen Halbbrücke oder alle Schalter der unteren Halbbrücke geschlossen sind. Diese Messung von Isolationsdefekten mittels Stromsensoren kann nur für den harten Erdschluss in einem TN-Netz (Terre Neutre Netz) verwendet werden. In einem IT-Netz treten aber bei einem Isolationsdefekt nur sehr kleine, durch die Messschaltung bestimmte Fehlerströme auf, so dass diese um Grössenordnungen kleiner sind als die im normalen Betrieb auftretenden Ströme, so dass dieser Ansatz für IT-Netze keine Relevanz hat.

EP 1 336 528 A2 zeigt eine Detektion von Erdfehlern indem die Spannung eines Zwischenkreiszweigs über eine Kapazität und einen Spannungsteiler ausgekoppelt, gleichgerichtet und gefiltert einem Komparator zugeführt wird. In anderen Varianten wird die Zweigspannung über einen Messtrafo erfasst, oder ein Umladestrom durch eine Kapazität zur Erde (C3). In jedem Fall kann also nur das Vorhandensein einer Wechselspannung erfasst werden, wie sie bei einem Erdfehler an einem Zweig auftreten kann. Es findet also keine Spannungsmessung der Zweigspannung zwischen den Zweigen statt, und ferner nur eine gefilterte Messung, also ohne dass ein aktueller Spannungswert für die momentane Zweigspannung ermittelt wird. Der Betriebszustand des Umrichters wird nicht berücksichtigt.

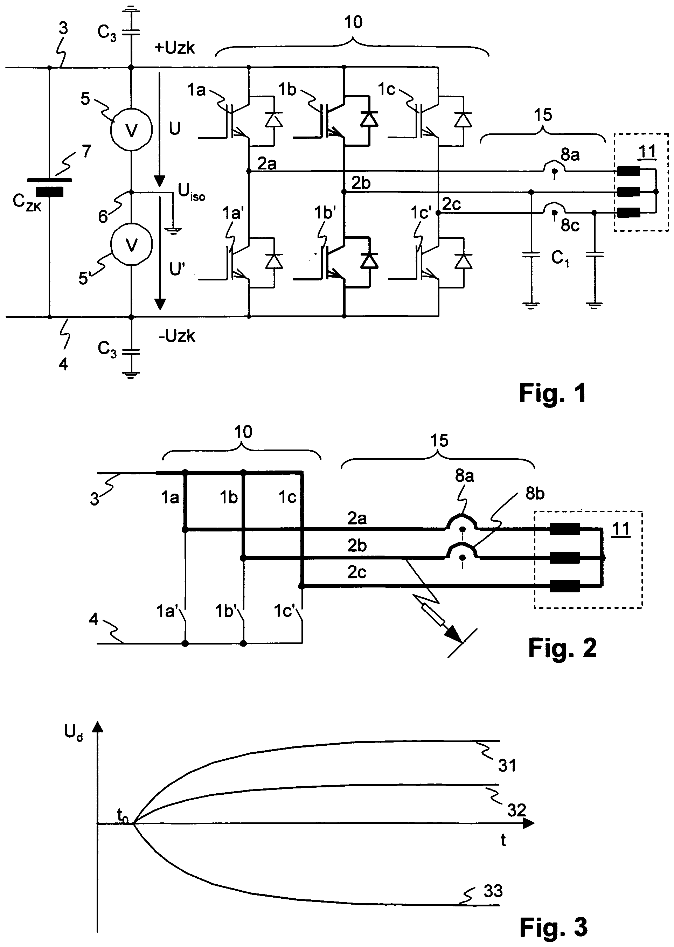

US 5,686,839 zeigt ein Verfahren zur Bestimmung von Erdfehlern, das ausgeführt wird, wenn der Motor nicht gespeist wird. Besondere, d.h. für den Normalbetrieb des Umrichters nicht erfoderliche, Messwiderstände (Nr. 22 in Fig. 2, siehe auch Spalte 7, ab Zeile 53) sind zwischen Erde und den Zwischenkreiszweigen angeordnet. Durch einem Erdfehler wird das Potential des Zwischenkreises gegenüber Erde definiert und es fliesst ein Erdfehlerstrom durch mindestens einen der Messwiderstände, so dass die Messspannung über diesen Widerständen einen Erdfehler anzeigt. Damit dieser Strom entsteht, werden beispielsweise alle oberen oder alle unteren Schalter des Wechselrichters geschlossen. In einer anderen Variante werden alle sechs Schalter einzeln ein- und ausgeschaltet. Die Differenz der Messspannungen kann zur Fehlerdetektion verwendet werden, jedoch können damit nur ohmsche Erdfehler detektiert werden. Die Fehlerdetektion während des Betriebs wird als unvorteilhaft betrachtet.

JP 2000 116144 soll einen Erdfehler während des Betriebes eines Umrichters detektieren, und basiert dabei auf einer Messung des Zwischenkreisstromes. Es wird zudem eine Schaltung verwendet, welche einen Zustand detektiert, in welchem alle Schalter einer Halbbrücke eines Wechselrichters eingeschaltet sind.

US 5 686 839 A zeigt die Detektion eines Fehlerstroms in elektrischen Fahrzeugen in Abhängigkeit von einer Ausgangsspannung und einem Ausgangsstrom eines Umrichters.

### DARSTELLUNG DER ERFINDUNG

Es ist deshalb Aufgabe der Erfindung, ein Verfahren und eine Vorrichtung zur Isolationsüberwachung für Umrichteranwendungen der eingangs genannten Art zu schaffen, welche eine geringere Störanfälligkeit aufweist.

Diese Aufgabe lösen ein Verfahren und eine Vorrichtung zur Isolationsüberwachung für Umrichteranwendungen mit den Merkmalen der entsprechenden unabhängigen Patentansprüche.

Das Verfahren wird also zur Überwachung einer Umrichteranwendung eingesetzt, wobei die Umrichteranwendung aufweist
- einen Spannungszwischenkreis mit mindestens einem positiven Zweig und einem negativen Zweig;
- mindestens ein elektrisches Gerät welches mindestens zwei Phasenanschlüsse aufweist;
- mindestens einen Umrichter mit Schaltelementen zur elektrischen Verbindung der Phasenanschlüsse mit dem positiven Zweig oder dem negativen Zweig des Spannungszwischenkreises;

Das Verfahren weist die Schritte auf:
- Bestimmen eines Betriebszustandes des Umrichters;
- Messen mindestens einer von einer Spannung des positiven Zweiges und einer Spannung des negativen Zweiges;
- Bestimmen von Isolationsdefekten am Spannungszwischenkreis und/oder an den Phasenanschlüssen und/oder am elektrischen Gerät nach Maßgabe der gemessenen Spannungen und des Betriebszustandes des Umrichters,
- Filtern einer Spannungsfunktion und Bestimmung von Signalanteilen der Spannungsfunktion in Frequenzbereichen entsprechend der Ausgangsfrequenz oder der Modulationsfrequenz des Umrichters; und
- Vergleich einer Amplitude des derart gefilterten Spannungssignals oder einer Gesamtenergie mehrerer derart gefilterter Signale mit einem Referenzwert und, falls dieser Referenzwert überschritten wird, Annahme eines Isolationsfehlers.

Die Umrichteranwendung weist mindestens ein von einem Umrichter gespeistes Gerät auf, kann aber auch mehrere Geräte aufweisen, die vom selben Umrichter gespeist werden, sowie mehrere Umrichter am selben Zwischenkreis. Die Geräte sind vorzugsweise elektrische Antriebe wie Asynchronmaschinen oder Synchronmaschinen, können aber auch andere Verbraucher oder Leistungsquellen wie Heizungen, Transformatoren, Batterien, Schweissanlagen, (Solar-)Generatoren etc. sein. Die Verbraucher können zwei-, drei- oder mehrphasig gespeist sein.

Vorzugsweise beruht das Bestimmen von Isolationsdefekten auf einer Differenz von Teilspannungen des Zwischenkreises, im Folgenden "Differenzspannung" genannt. Es wird also die Überwachung der Isolation lediglich mit den ohnehin im Umrichter vorhandenen Mitteln durchgeführt, insbesondere anhand der Messungen der Zwischenkreisspannung, welche für die Umrichterregelung erforderlich ist, und anhand des Betriebszustandes, welcher durch die Umrichterregelung vorgegeben wird. Es werden keine zusätzlichen Messeinrichtungen für die Isolationsüberwachung verwendet, oder Messeinrichtungen, die nur zur Isolationsüberwachung benutzt werden. Dadurch besteht keine Gefahr von zusätzlichen Fehlern, wie sie beim Stand der Technik durch zusätzliche Messvorrichtungen oder Messsignaleinspeisungen entstehen können.

Anstelle der Differenzspannung können auch andere, mathematisch im wesentlichen äquivalente und in anderer Weise von den Teilspannungen abgeleitete Grössen (auch "Spannungsfunktionen" genannt) verwendet werden. Diese enthalten die gleiche Information. Beispielsweise ist die Zwischenkreisspannung, falls sie z.B. durch ihre Speisung - typischerweise eine Batterie oder ein Gleichrichter - auf einen konstanten Wert geregelt ist, bekannt. Aus der einen Teilspannung und der Zwischenkreisspannung kann somit die zweite Teilspannung berechnet werden, und daraus wiederum die Differenzspannung. Somit ist die gesamte Information der beiden Teilspannungen auch im Wissen um die (vorgegebene) Zwischenkreisspannung und eine der Teilspannungen enthalten. Deshalb kann anstelle der Differenzspannung auch beispielsweise das Verhältnis einer der Teilspannungen zur Zwischenkreisspannung verwendet werden. Wenn die Zwischenkreisspannung konstant ist, kann alternativ auch eine der Teilspannungen alleine verwendet werden.

Die erfindungsgemässe Überwachungseinrichtung kennt also den Betriebszustand des Umrichters und/oder kann den Betriebszustand selber vorgeben. Damit ist es möglich, viel gezielter auf den aktuellen Zustand eingehen zu können. Einerseits kann somit ein allfälliger Fehler örtlich präziser erfasst werden, andererseits können Schwellwerte, deren Überschreiten eine Fehleranzeige auslöst, an den Betriebszustand angepasst werden. Insbesondere kann bei der Messung der systembedingten kapazitiven Fehlerströme der Zustand des oder der Antriebe respektive deren Einzelumrichter berücksichtigt werden, und es lassen sich Warn- und Fehlergrenzen genauer festlegen.

In einer bevorzugten Variante der Erfindung weist also der Schritt des Bestimmens von Isolationsdefekten die folgenden Teilschritte auf:
- Erfassen von Werten von charakterisierenden Grössen der Differenzspannung (oder einer äquivalenten Grösse) des Zwischenkreises;
- Vergleich der erfassten Werte mit Referenzwerten, und, falls eine Abweichung von den Referenzwerten ein vorgegebenes Mass überschreitet, Signalisieren eines Isolationsfehlers.

Die genannten charakterisierenden Grössen sind vorzugsweise ein zeitlicher Verlauf der Differenzspannung, oder Werte von weiteren Grössen, die diesen zeitlichen Verlauf charakterisieren. Solche weiteren charakterisierenden Grössen sind beispielsweise eine Zeit bis zum Überschreiten eines vorgegebenen Schwellwertes, eine Anstiegszeit, eine Zeitkonstante eines Einschwingvorgangs, eine Folge von Werten der Funktion, eine Einschwingzeit, ein stationärer Endwert, ein Integral, ein Wert der Funktion zu einer vorgegebenen Zeit nach dem Schalten der Schalter gemäss der Testkonfiguration, etc. In einer bevorzugten Ausführungsform der Erfindung wird aus dem Wert einer solchen Grösse ein Wert entsprechend einem Betrag eines kapazitiven Erdfehlers berechnet. Beispielsweise entsprechen grössere Zeitkonstanten einer grösseren Fehlerkapazität.

In anderen bevorzugten Ausführungsformen der Erfindung sind charakterisierende Grössen aus einer Analyse der Differenzspannung im Frequenzbereich abgeleitet. Dies sind insbesondere Amplituden oder Energieanteile der Differenzspannung in einem bestimmten Frequenzbereich, also nach einer Filterung.

Referenzwerte sind analog dazu Werte von charakterisierenden Grössen, die vorzugsweise experimentell in einer Teach-In Phase bei der Inbetriebnahme der Umrichtereinrichtung erfasst werden und einem nominellen Zustand bei guter Isolation repräsentieren.

Grundsätzlich kann jedes Überschreiten eines Grenzwertes zu der Annahme führen, dass ein Isolationsfehler vorliegt. Wie auf diese Annahme reagiert wird, hängt von den Umständen und der Art des vermuteten Fehlers ab: Eine Annahme kann unmittelbar einen Alarm oder eine Warnanzeige auslösen, kann aber auch zusammen mit weiteren Indikatoren verarbeitet werden, so dass beispielsweise eine Bestätigung durch Messungen mit Verfahren gemäss anderen Varianten der Erfindung oder zu einem anderen Zeitpunkt oder in einem anderen Betriebszustand verlangt wird, um eine Annahme zu erhärten und einen Alarm auszulösen.

Ferner kann eine durch eine Extremsituation (Nässe und/oder Verschmutzung) verursachte temporäre Erhöhung der kapazitiven oder ohmschen Fehlerströme durch eine Warnung sichtbar gemacht werden. Nach Beheben der Ursache (Trocknen / Reinigung) zeigt der Wegfall der Warnung an, dass diese Behebung erfolgreich durchgeführt wurde.

Das Bestimmen von charakteristischen Grössen der Differenzspannung geschieht gemäss verschiedenen Ausführungsformen der Erfindung vorzugsweise indem
- in einer Initialisierungsphase oder Testphase die Schalter gemäss einer Vorgabe der Isolationsmessvorrichtung angesteuert werden, und die Differenzspannung im Zeitbereich analysiert wird; oder
- in einer Betriebsphase die Schalter durch die konventionelle Umrichterregelung angesteuert werden, und die Differenzspannung im Frequenzbereich analysiert wird, wobei Information über den Betriebszustand der Umrichterregelung vorzugsweise mitverwendet wird.

In einer ersten bevorzugten Variante der Erfindung werden also zur Bestimmung des Betriebszustandes Schalterpositionen des Umrichters vorgegeben und die Schalter, typischerweise Leistungshalbleiter, des Umrichters gemäss dieser Vorgabe geschaltet. Der Betriebszustand des Umrichters ist in dieser Variante durch Schalterstellungen seiner Schaltelemente charakterisiert. Durch Einbezug dieser in den Umrichtern vorhandenen Leistungsschalter ist es möglich, den Ort des Isolationsfehlers Teilnetzen zu zuordnen und damit genaue Hinweise auf die zu ersetzenden Geräte oder Verkabelungen zu geben. Vorzugsweise geschieht dies nicht im Normalbetrieb des Umrichters und des angeschlossenen Antriebes oder Gerätes, sondern in einer Initialisierungsphase oder Testphase beim Starten des Gerätes respektive bei stillstehendem Antrieb.

So kann die Überwachungseinrichtung in eine Umrichtersteuerung integriert werden. Es sind also vorzugsweise, im Vergleich zu einer bestehenden Umrichtersteuerung, keine weiteren physischen Komponenten erforderlich, insbesondere keinerlei aktiven Mittel zum Einspeisen von Messignalen, und nebst der für eine moderne Antriebsregelung ohnehin erforderlichen Zwischenkreismessung auch keine weiteren physischen Messeinrichtungen. Im Falle einer mikroprozessorgesteuerten Umrichterregelung kann lediglich deren Software erweitert werden, um das Verfahren zur Isolationsüberwachung zu realisieren.

Beispielsweise werden, in einer bevorzugten Variante der Erfindung, einzelne oder alle Schalter einer Halbbrücke eingeschaltet (geschlossen), währenddem die Schalter auf der gegenüberliegenden Halbbrücke offen, also nicht leitend bleiben. Dadurch sind einer oder mehrere oder alle Phasenanschlüsse nur mit einem Zweig des Zwischenkreises verbunden, und verbleibenden (gegebenenfalls keine) Phasenanschlüsse nicht mit dem gegenüberliegenden Zweig verbunden. Es kann also - sofern kein ohmscher Isolationsfehler vorliegt - kein dauernder Strom in das Gerät fliessen. In einer transienten Phase findet aber eine Umladung in Kapazitäten der Leitungen und Geräte statt, so dass anhand von resultierenden kurzzeitigen Einbrüchen der Zwischenkreisspannungen, die insbesondere in der Differenzspannung sichtbar werden, ein Rückschluss auf diese Kapazitäten möglich ist. Im Falle von ohmschen Isolationsfehlern verschiebt sich das Spannungsniveau des ganzen Zwischenkreises, was zu einer stationären Verschiebung der Differenzspannung führt, solange die Halbbrücke durchgeschaltet ist.

Dadurch sind Isolationsfehler in einem Gerät oder dessen Zuleitung messbar. Falls mehrere Umrichter am selben Zwischenkreis angeschlossen sind, kann dies sequentiell mit jedem einzelnen Umrichter durchgeführt werden, um die Isolationsgüte des jeweils zugeordneten Gerätes oder seiner Zuleitung zu bestimmen.

In einer weiteren bevorzugten Variante der Erfindung wird - nachdem wieder der stationäre Zustand erreicht ist, wobei alle Schalter geöffnet sind - dieser Vorgang für die gegenüberliegende Halbbrücke wiederholt, so dass also eine Umladung in umgekehrter Richtung erfolgt. Eine Asymmetrie zwischen den beiden Umladevorgängen zeigt eine Asymmetrie der Zwischenkreisspannungsmessungen auf und kann so zur Überprüfung der Zwischenkreisspannungsmessung selber verwendet werden. Die Asymmetrie zeigt sich auch, wenn die Werte der beiden gegenpoligen Messungen ohne Berücksichtigung des Vorzeichens miteinander verglichen werden, also beispielsweise durch Bildung der Differenz der Absolutwerte der beiden Messungen.

In einer weiteren bevorzugten Variante der Erfindung werden die folgenden Schritte ausgeführt:
- gleichzeitiges und kurzzeitiges Einschalten mehrerer Schalter zur Verbindung von mindestens einem der Phasenanschlüsse mit einem ersten Zweig und mindestens einem anderen der Phasenanschlüsse mit einem zweiten Zweig des Umrichters;
- Messung von mindestens einem Strom durch einen der so verbundenen Phasenanschlüsse während des Einschaltens;
- Feststellen, ob mindestens eine Verbindung des Phasenanschlusses zum Gerät unterbrochen ist, nach Massgabe der mindestens einen Strommessung.

Damit lässt sich, zusätzlich zur Isolationsüberwachung, auch eine Kontrolle der Durchgängigkeit der Geräteanschlüsse durchführen, ohne dass weitere Messmittel erforderlich sind, als in einer modernen Antriebssteuerung ohnehin schon vorliegen. In diesem Fall werden noch Stromsensoren zur Messung des Stromes in den Phasenanschlüssen, also durch die Geräteanschlüsse. verwendet. Solche Stromsensoren (mindestens zwei) sind bei einem dreiphasigen Antrieb in der Regel ohnehin schon vorgesehen. Grundsätzlich ist diese Variante zur Bestimmung, ob eine Verbindung zum Gerät unterbrochen ist, auch unabhängig von der Isolationsüberwachung implementierbar.

Die Erfindung weist der Schritt des Bestimmens des Betriebszustandes auf:
- Erfassen von Parametern der Umrichtersteuerung während des Normalbetriebs (in Gegensatz zu einem Testbetrieb) des Umrichters und des gespeisten Gerätes;
- wobei diese Parameter zumindest eine von Ausgangsfrequenz, und Modulationsfrequenz, und optional auch Ausgangsspannung und/oder Ausgangsstrom des Umrichters umfassen.

Die Ausgangsfrequenz und Ausgangsspannung werden in der Antriebstechnik auch Statorfrequenz und Statorspannung genannt, und werden im Folgenden austauschbar verwendet. Die Ausgangsfrequenz ist typischerweise gleich der Frequenz der geglätteten pulsmodulierten Ausgangsspannung (Grundharmonische). Diese Grundfrequenz wird einer höheren (PWM)-Modulationsfrequenz aufmoduliert. Die Ausgangsspannungen der drei Phasenanschlüsse werden auf dieselbe Spannung und Frequenz gesteuert und unterscheiden sich nur durch ihre Phase.

Das Verfahren wird vorzugsweise in einer Betriebsphase im Normalbetrieb des Umrichters respektive des Gerätes ausgeführt. Der Betriebszustand des Umrichters ist also insbesondere durch die Ausgangsfrequenz und/oder durch die Modulationsfrequenz des Umrichters charakterisiert. Diese Frequenzkomponenten der Umrichterspannung führen auch zu entsprechenden Strömen durch parasitäre Störkapazitäten und Fehlerkapazitäten und damit zu Veränderungen in den beiden Teilspannungsmessungen, so dass sich die Veränderung von Isolationsfehlerimpedanzen anhand der Änderung dieser Teilspannungen, insbesondere der Differenzspannung, feststellen lässt.

Anhand der bekannten Ausgangsfrequenz und/oder der Modulationsfrequenz werden die gemessenen Zwischenkreisspannungen speziell auf Änderungen respektive Störungen in diesen Frequenzbereichen analysiert. Dazu werden also, abhängig vom aktuellen Betriebszustand des Antriebes, Filtereinstellungen bei der Filterung der Zwischenkreisspannungen oder davon abgeleiteten Signalen (auch Spannungsfunktionen genannt) vorgenommen.

Somit werden Störungen in anderen Frequenzbereichen, welche nicht von Isolationsfehlern stammen, eliminiert. Damit wiederum können Schwellwerte zur Erkennung von Fehlerzuständen präziser gesetzt werden. Auch können Störungen, in Abhängigkeit der betroffenen Frequenz, demjenigen Umrichter zugeordnet werden, der momentan mit dieser Frequenz arbeitet. Dies ist im Gegensatz zum Stand der Technik, gemäss welchem die Signale durch Tiefpassfilter mit sehr grossen Zeitkonstanten bearbeitet werden, was zu langen Ansprechzeiten führt.

Dadurch dass die Isolationsmessung die bereits vorhandene Messeinrichtung der Zwischenkreisspannung mit verwendet, ist sicher gestellt, dass diese korrekt funktioniert: Vor allem in modernen Antrieben kommt der Zwischenkreisspannungsmessung eine entscheidende Aufgabe zu, da diese Messung die Regelgüte des Antriebs wesentlich beeinflusst. Bereits kleinere Abweichung führen zu Störungen des Antriebs, so dass eine schleichende Zunahme eines Messfehlers in der Regelung bemerkbar wird, bevor die Isolationsmessung falsche Ergebnisse liefert.

In einer weiteren bevorzugten Variante des Erfindungsgegenstandes wird deshalb die Messung der Zwischenkreisspannung anhand des Verhaltens der Antriebsregelung überwacht und auf diese Weise eine Selbstüberwachung der Spannungsmessung realisiert. Falls die Antriebsregelung korrekt arbeitet (also beispielsweise Spannungen und Ströme nicht in den Anschlag gelangen), wird angenommen, dass die Messungen der Zweigspannungen ebenfalls korrekt funktionieren.

Ein Verfahren zur Herstellung eines Überwachungsgerätes zur Isolationsüberwachung für Umrichteranwendungen weist die folgenden Schritte auf:
- Bereitstellen einer Datenverarbeitungseinheit und einer Speichereinheit des Überwachungsgerätes sowie von Messeingängen oder Kommunikationsmitteln zur Erfassung von Messwerten und deren Übermittlung an die Datenverarbeitungseinheit;
- Speichern eines Programmcodes in einer Speichereinheit des Überwachungsgerätes;
- wobei der Programmcode bei seiner Ausführung die Datenverarbeitungseinheit zur Ausführung des oben beschriebenen Verfahrens bringt.

Weitere bevorzugte Ausführungsformen gehen aus den abhängigen Patentansprüchen hervor. Dabei sind Merkmale der Verfahrensansprüche sinngemäss mit den Vorrichtungsansprüchen kombinierbar und umgekehrt.

### KURZE BESCHREIBUNG DER ZEICHNUNGEN

Im folgenden wird der Erfindungsgegenstand anhand von bevorzugten Ausführungsbeispielen, welche in den beiliegenden Zeichnungen dargestellt sind, näher erläutert. Es zeigen jeweils schematisch:
- Figur 1: eine Umrichteranordnung;
- Figur 2: eine Schalterkonfiguration zur Isolationsmessung;
- Figur 3: Trajektorien von Differenzspannungen bei der Isolationsmessung;
- Figur 4: eine Umrichteranordnungen mit eingezeichnen Umrichtersteuerungen;
- Figur 5: eine Schalterkonfiguration zur Durchgängigkeitsbestimmung;
- Figur 6: einen Verlauf einer Differenzspannung;
- Figur 7: Frequenzspektrum einer Differenzspannunngsverlaufes;
- Figur 8: eine Frequenz-Spannungs-Kennlinie eines Antriebsumrichters; und
- Figur 9: eine Messanordnung zur Messung von Zwischenkreisspannungen.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### WEGE ZUR AUSFÜHRUNG DER ERFINDUNG

**Figur 1** zeigt eine Umrichteranordnung: Ein Zwischenkreis 7 mit einer Zwischenkreis-Kapazität C_{ZK} wird durch eine (nicht gezeichnete) Quelle gespeist, beispielsweise einen aktiven oder passiven Gleichrichter (direkt oder über ein Gleichstromnetz) oder eine Batterie, welche direkt oder über einen Gleichspannngssteller angeschlossen sein kann. Ein Gleichrichter ist typischerweise durch einen Transformator oder einem Generator gespeist. Ein Nullpunkt 6 des Zwischenkreises 7 ist mit Erde, einem Fahrzeugchassis und / oder mit Gehäuseteilen der Geräte im IT-Netz elektrisch verbunden. Der Zwischenkreis 7 weist einen positiven Zweig 3 auf, dessen Spannung +U_{ZK} bezüglich des Nullpunktes 6 durch eine erste Zweigspannungsmessung 5 messbar ist, und einen negativen Zweig 4, dessen Spannung -U_{ZK} durch eine zweite Zweigspannungsmessung 5' messbar ist. Ein Umrichter 10 ist in bekannter Weise durch elektronische Leistungsschalter gebildet, die zusammenfassend mit dem Bezugszeichen 1 bezeichnet sind. Ein erste Gruppe dieser Schalter 1 mit den Bezugszeichen 1a, 1b, 1c bildet eine obere Halbbrücke, eine zweite Gruppe 1a', 1b', lc' bildet eine untere Halbbrücke. Die Schalter 1 verbinden Phasenanschlüsse 2a, 2b, 2c (zusammenfassend mit dem Bezugszeichen 2 bezeichnet) wahlweise mit dem positiven Zweig 3 oder dem negativen Zweig 4. Durch beispielsweise eine Pulsweitenmodulation werden so in bekannter Weise die Spannungen Ua, Ub, Uc an den Phasenanschlüssen 2 gesteuert. In der Figur 1 sind als Schalter 1 IGBTs (Insulated Gate Bipolar Transistor) gezeichnet, die Erfindung ist aber unabhängig vom Schaltertyp beispielsweise auch mit MOSFETs, GTOs, Thyristoren etc. realisierbar.

An den Phasenanschlüssen 2 ist über eine Leitung 15 ein Antrieb 11 angeschlossen. oder allgemein ein Gerät 11 mit Geräteimpedanzen Xa, Xb, Xc. Im Folgenden ist der Erklärung halber von einem Antrieb 11 die Rede, obschon die Erfindung prinzipiell für angeschlossene Geräte beliebiger Art einsetzbar ist. Der Antrieb 11 oder die Leitungen 15 können über Strommesser 8a, 8c zur Messung des Stromes durch die Phasenanschlüsse 2 verfügen.

An den Leitern der Leitung 15 sind parasitäre Kapazitäten C₁ eingezeichnet, welche Leitungs- und Antriebskapazitäten repräsentieren. Ebenso sind weitere Kapzitäten C₃ zwischen dem positiven Zweig 3 respektive dem negativen Zweig 4 und dem Nullpunkt 6 eingezeichnet. Diese Kapazitäten C₃ sind entweder auch parasitärer Art, oder sind bewusst eingefügte Kondensatoren. Die genannten Kapazitäten C₁, C₃ tragen zur Störung von konventionellen Isolationsprüfverfahren bei.

Die Isolationsdefekte werden anhand einer Differenz von Teilspannungen des Zwischenkreises detektiert. Vorzugsweise wird ausschliesslich diese Differenz verwendet, so dass also keine weiteren Messeinrichtungen benötigt werden. Die Teilspannungen sind einerseits die Spannung U zwischen dem Nullpunkt 6 und dem positiven Zweig 3 und andererseits die Spannung U' zwischen dem negativen Zweig 4 und dem Nullpunkt 6. Im Nominalzustand ist die Differenz Ud=U-U' dieser beiden Spannungen Null. Ihre Summe U+U' ist in jedem Zustand gleich der Zwischenkreisspannung Uzk.

Die Erklärung geschieht nachfolgend anhand der Differenzspannung, Grundsätzlich kann aber die Analyse von anderen abgeleiteten Signalen, die aus einer einzelnen Teilspannnung oder einer Kombination der beiden Teilspannungen hervorgehen, in analoger Weise durchgeführt werden. D.h. dass z.B. stationäre Endwerte, Zeitkonstanten von transienten Vorgängen und Analysen im Frequenzbereich bei solchen abgeleiteten Signalen ebenfalls durch ihre zeitliche Änderung und durch Vergleiche mit Referenzwerten zur Detektion von Isolationsfehlern und/oder Fehlern in der Messwerterfassung verwendbar sind.

Zur Bestimmung von Isolationsfehlern werden in einer bevorzugten Variante der Erfindung Schalterpositionen oder Schalterkonfigurationen des Umrichters 10 vorgegeben und die Schalter 1 des Umrichters 10 gemäss dieser Vorgabe angesteuert:

**Figur 2** zeigt eine solche Schalterkonfiguration zur Isolationsmessung. Alle Phasenanschlüsse 2 werden gleichzeitig durch die entsprechenden Schalter 1a, 1b, 1c der oberen Halbbrücke mit dem positiven Zweig 3 verbunden. Allgemein ausgedrückt geschieht dabei:
- in einer ersten Testkonfiguration, ein gleichzeitiges Einschalten eines oder mehrerer Schalter zur Verbindung nur eines ersten (also nur des positiven oder nur des negativen) Zweiges 3; 4 des Umrichters mit einem oder mehreren Phasenanschlüssen 2, wobei der zweite, gegenüberliegende (also der negative respektive der positive) Zweig 4; 3 nicht mit den Phasenanschlüssen 2 verbunden wird.

Tritt ein Isolationsfehler auf, so bleibt die Summenspannung im Wesentlichen konstant, das Spannungsniveau des positiven Zweiges 3 und des negativen Zweiges 4 bezüglich dem Nullpunkt 6 verschiebt sich aber, und es entsteht eine von Null verschiedene Differenzspannung.

**Figur 3** zeigt dabei resultierende Trajektorien von Differenzspannungen Ud = U-U' über die Zeit t nach dem Einschalten der Schalter 1 zum Zeitpunkt t₀. Im Idealfall, ohne Isolationsfehler, würde die Differenzspannung Null bleiben. Eine erste Trajektorie 31 und eine zweite Trajektorie 32 entsprechen unterschiedlich grossen Isolationsfehlern beim Einschalten beispielsweise der oberen Schalter 1a, 1b, 1c. Ein Isolationsfehler kann beispielsweise angenommen werden, wenn der stationäre Endwert oder der Wert der Differenzspannung nach einer vorgegebenen Zeit einen vorgegebenen Referenzwert überschreitet. Der stationäre Endwert ist primär eine Funktion eines ohmschen Isolationsfehlers. Wird ein vorgegebener Referenzwert überschritten, so wird ein Isolationsfehler angenommen. Steigt dieser stationäre Endwert im Verlauf der Zeit, also bei mehreren Tests, die in zeitlichen Abständen wiederholt werden, zu schnell, so kann ebenfalls ein Isolationsfehler angenommen werden.

Aus der Zeitkonstanten der Trajektorien kann ebenfalls auf die Isolationsgüte geschlossen werden. Vergrössert sich die Zeitkonstante im Verlauf der Zeit (also über Minuten bis Tage hinweg), so wird eine Zunahme der parasitären Kapazitäten angenommen. Überschreitet die Zeitkonstante einen Referenzwert, so wird ein kapazitiver Isolationsfehler angenommen. Die Zeitkonstante ist also ein Mass für den Betrag eines kapazitiven Erdfehlers. Anstelle der Zeitkonstante können vorzugsweise auch andere Variablen, welche ebenfalls den zeitlichen Verlauf oder die Trajektorie der Funktion beschreiben (und nicht nur einen Momentanwert), ausgewertet werden. Solche Variablen sind beispielsweise eine Folge von Werten der Funktion zu bestimmten Abtastzeitpunkten, ein Integral der Funktion über eine vorgegebene Zeitdauer, oder ein Wert der Funktion zu einer vorgegebenen Zeit nach dem Schalten der Schalter gemäss der Testkonfiguration.

Wie genau die charakteristischen Werte interpretiert und zueinander in Beziehung gesetzt werden hängt von den jeweiligen Verhältnissen einer Anlage ab, insbesondere von den relativen und absoluten Dimensionen der Leitungen, Geräte, Spannungsniveaux, Strömen etc. Ähnliche Verläufe treten auch bei anderen Spannungsfunktionen auf.

Die dritte Trajektorie 33 ist das beispielhafte Ergebnis, wenn in einer zweiten Testkonfiguration nur der negative Zweig 4 über untere Schalter 1a', 1b', lc' mit den Phasenanschlüssen 2 verbunden wird. Falls die zweite Trajektorie 32 von derselben Anlage beim Einschalten der oberen Schalter stammt, müsste die dritte Trajektorie 33 symmetrisch zur zweiten Trajektorie 32 verlaufen. Ist dies nicht der Fall, sind also die Funktionen der Spannungen bei den beiden Testkonfigurationen zueinander asymmetrisch, so wird beim Überschreiten einer bestimmten Abweichung von der Symmetrie ein Fehler in der Spannungsmessung angenommen. Als Mass für die Abweichung kann beispielsweise eine Abweichung der Absolutbeträge der stationären Endwerte oder der Integrale der Trajektorien 32, 33 dienen.

Im Prinzip ist auch eine differenzierte Analyse der Isolation der einzelnen Leiter möglich, indem nur einzelne der Phasenanschlüsse 2 mit einem Zweig verbunden werden.

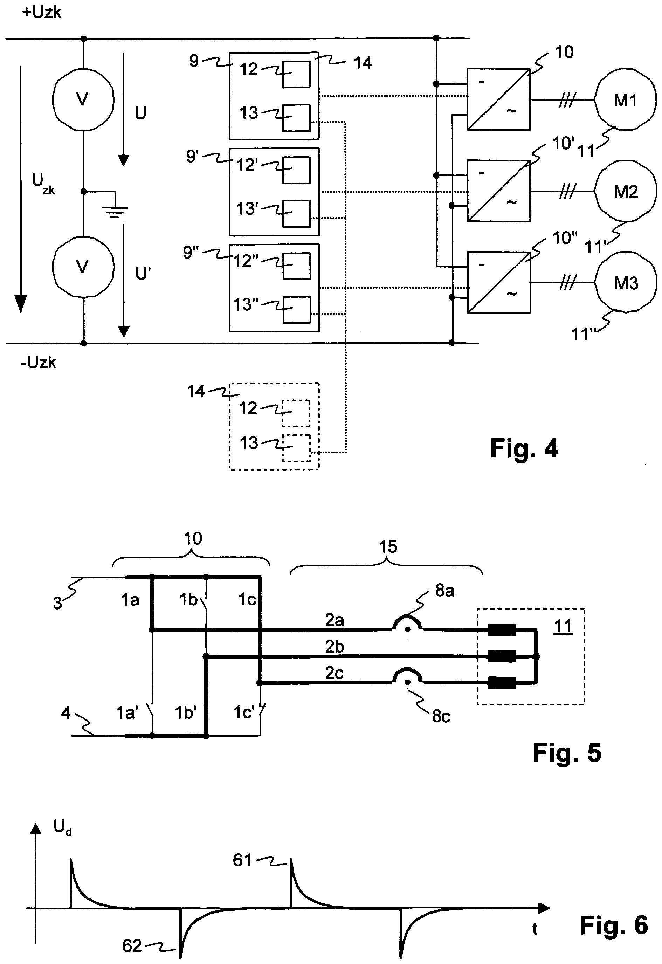

**Figur 4** zeigt eine Umrichteranordnung mit eingezeichneten Umrichtersteuerungen. Es sind mehrere Umrichter 10, 10', 10" mit jeweils zugeordneten Geräten oder Antrieben 11, 11', 11" am selben Zwischenkreis 7 angeschlossen (die Zwischenkreiskapazität ist nicht eingezeichnet). Jedem der Umrichter 10, 10', 10" ist eine Umrichtersteuerung 9, 9', 9" zugeordnet. Regelungstechnisch betrachtet sind die Umrichtersteuerungen 9, 9', 9" separate Entitäten, auch wenn sie real auf einer gemeinsamen Hardwareeinheit implementiert sein können. Für die folgende Erklärung wird beispielhaft angenommen, dass jede der Umrichtersteuerungen 9, 9', 9" über eine eigene Datenverarbeitungseinheit 12, 12', 12" verfügt. Zudem kann jede der Umrichtersteuerungen 9, 9', 9" - je nach der Art des zugeordneten Gerätes oder Antriebs 11, 11', 11"- über Messmittel verfügen. Diese Messmittel sind
- Messeinrichtungen für die Zwischenkreisspannungen, Ströme durch die Phasenanschlüsse 2, Drehzahlen und andere Gerätegrössen, oder
- Kommunikationseinrichtungen 13 wie Feldbusse, welche zum Empfang solcher Messgrössen eingerichtet sind. Die Übermittlung von Messgrössen oder Stellsignalen ist durch strichlierte Linen angedeutet.

Eine Isolationsüberwachungsvorrichtung 14 kann als separate Einheit (strichpunktiert eingezeichnet) oder als Teil einer der Umrichtersteuerungen 9, 9', 9" ausgebildet sein. Vorzugsweise weist die Isolationsüberwachungsvorrichtung 14 auch Kommunikationseinrichtungen 13 zum Empfang von Betriebsparametern anderer Umrichtersteuerungen 9, 9', 9" auf.

Das oben beschriebene Verfahren, bei welchem nur einer der Umrichterzweige 3, 4 mit einem Antrieb 11 verbunden wird, wird in einer Konfiguration gemäss der Figur 4 nacheinander für jeden der Umrichter 10, 10', 10" respektive Antriebe 11, 11', 11" durchgeführt. Also wird die genannte erste und evtl. auch die zweite Testkonfiguration jeweils separat durch genau einen der mehreren Umrichter 10, 10', 10" eingestellt, wobei die anderen Umrichter 10, 10', 10" ausgeschaltet bleiben. Damit lässt sich eruieren, in welchem Gerät 11, 11', 11" respektive an welchen Phasenanschlüssen ein Isolationsfehler vorliegt. Dazu sind die Umrichtersteuerungen 9, 9', 9" jeweils von der Isolationsüberwachungsvorrichtung 14 über die Kommunikationseinrichtungen 13, 13', 13" zum Schalten der Testkonfigurationen ansteuerbar. Die Kommunikationseinrichtungen 13, 13', 13" fungieren hier also als Steuermittel.

**Figur 5** zeigt eine Schalterkonfiguration zur Kontrolle der Durchgängigkeit der Geräteanschlüsse. Mindestens ein Phasenanschluss 2a, 2c wird auf den positiven Zweig 3 und mindestens ein weiterer Phasenanschluss 2b auf den negativen Zweig 4 geschaltet. Unter Verwendung von Strommessungen 8a, 8c, welche bei Antriebssteuerung oft ohnehin vorhanden sind, wird die Durchgängigkeit der Verbindungen eruiert. Im gezeigten Beispiel sind zwei Phasenanschlüsse 2a, 2c mit dem einen und der verbleibende Phasenanschluss 2b mit dem anderen Zweig verbunden. Der verbleibende Phasenanschluss ist dabei derjenige, der nicht über eine Strommessung verfügt (aus Kostengründen wird eine redundante Messung weggelassen). Wenn einer der beiden gemessenen Ströme null ist, so ist der entsprechende Phasenanschluss 2a oder 2c unterbrochen, wenn beide null sind, ist der verbleibende Phasenanschluss 2b unterbrochen.

Falls nicht a priori bekannt ist, welcher der Phasenanschlüsse 2 ohne Strommessung ist, werden alle drei möglichen Schalterkonfigurationen mit "zwei Schalter oben zu - ein Schalter unten zu" probiert. Falls jedesmal in beiden Messungen 8a, 8c ein Strom gemessen wird, sind alle Phasenanschlüsse 2 respektive Leitungen 15 durchgängig.

Durch Ändern der Schalterkonfiguration wird auch das Erkennen und Lokalisieren von Kurzschlüssen zwischen leistungsübertragenden Leitern 15 möglich. Wird nämlich nur eine Schalterkonfiguration getestet, kann ein Kurzschluss zwischen den mit dem gleichen Zweig 3, 4 verbundenen Leitungen 15 nicht erkannt werden, es sei denn dass die Leitungen 15 mittels PWM (Pulsweitenmodulation) mit unterschiedlichen Spannungen versorgt werden und die Auswertung des sich einstellenden Stromes im entsprechenden Zweig 3, 4 dies berücksichtigt.

Es kann für den Personen- und Hardwareschutz wichtig sein, Leitungsunterbrüche und/oder solche Kurzschlüsse zu detektieren. Wird zum Beispiel die beschriebene Kurzschlussüberwachung bei reduzierter Zwischenkreisspannung, z.B. während der Vorladung des Zwischenkreiskondensators, durchgeführt, so können dies die Halbleiterschalter unbeschädigt überstehen, auch wenn diese einen höheren Kurzschlussstrom nicht überleben, wie er durch die volle Zwischenkreisspannung verursacht würde.

In einer bevorzugten Ausführungsform der Erfindung werden zu dieser Bestimmung von Kurzchlüssen zwischen Leitungen die folgenden Schritte durchgeführt:
- Laden oder Entladen des Zwischenkreises auf eine reduzierte Zwischenkreisspannung, oder, alternativ, Laden auf die volle (nominelle) Zwischenkreisspannung.
- Kurzzeitiges Anlegen unterschiedlicher Spannungspotentiale an mindestens zwei Phasenanschlüsse 2a, 2b, 2c mittels der Schaltelemente 1 des Umrichters. Dies kann durch unmoduliertes Verbinden oder durch aufmodulierten einer Spannung geschehen. Die Zeitdauer, während der die Spannung angelegt wird, ist vorzugsweise weniger als 50, insbesondere weniger als 5 Millisekunden.
- Auswerten mindestens eines sich einstellenden Stromes und/oder Auswerten des Ansprechens einer Kurzschlussüberwachung. Die Kurzschlussüberwachung kann beispielsweise mittels Stromsensoren in den Phasenanschlüssen oder den Umrichterzweigen geschehen, oder durch Überwachung der Spannung über den Schaltern: im Normalfall ohne Kurzschluss würde die (Kollektor-Emitter) Spannung an einem geschlossenen Schalter einen bestimmten Wert nicht überschreiten.
- Feststellen, entsprechend dieser Auswertung(en) ob mindestens zwei Phasenanschlüsse 2a, 2b, 2c kurzgeschlossen sind.

Die letzten drei Schritte werden vorzugsweise mit anderen Spannungspotentialen wiederholt, falls das sichere Detektieren eines Kurzschlusses sonst nicht möglich ist. Die obigen Schritte zur Bestimmung von Kurzschlüssen zwischen Leitungen 15 oder Phasenanschlüssen 2a, 2b, 2c können auch unabhängig von den anderen in dieser Patentanmeldung beschriebenen Verfahren ausgeführt werden.

**Figur 6** zeigt einen Verlauf einer Differenzspannung im Zeitbereich während des Betriebs eines Umrichters 10. Jedes Umschalten eines Phasenanschlusses 2 vom einen zum anderen Zweig führt zu einer stossartigen und dann abklingenden positiven 61 respektive negativen Spitze 62. Der Abstand aufeinanderfolgender Spitzen ist eine Funktion der Modulationsfrequenz des Umrichters, ihre Höhe und Abfallzeit ist eine Funktion der Kapazitäten in Leitungen 15 und Antrieben 11. Beim Vorliegen mehrerer Umrichter 10, 10', 10" überlagern sich die Spitzen entsprechend.

In einer bevorzugten Ausführungsform der Erfindung wird ein Selbsttest der Isolationsüberwachung respektive der Vorrichtung 14 wie folgt durchgeführt. Falls bekannt ist, beispielsweise in einem Testbetriebszustand, dass keine Leitungen 15 angeschlossen sind, liegen keine Kabelkapazitäten vor und sollten die Spitzen viel kleiner sein als wenn eine Leitung 15 angeschlossen ist. Es wird also ein Mass für die Grösse der Spitzen, also ein Mass einer transienten Abweichung der Funktion von einem Referenzwert gebildet. Dies ist beispielsweise eine charakterisierende Grösse wie eine Amplitude der Spitze, ein Integral von Absolutwerten, ein RMS-Wert etc., jeweils entweder gefiltert oder ungefiltert. Wenn dieses Mass in diesem Testbetriebszustand eine vorgegebene Grösse überschreitet, wird angenommen, dass ein Fehler in der Isolationsüberwachung selber vorliegt, insbesondere in der Messwerterfassung.

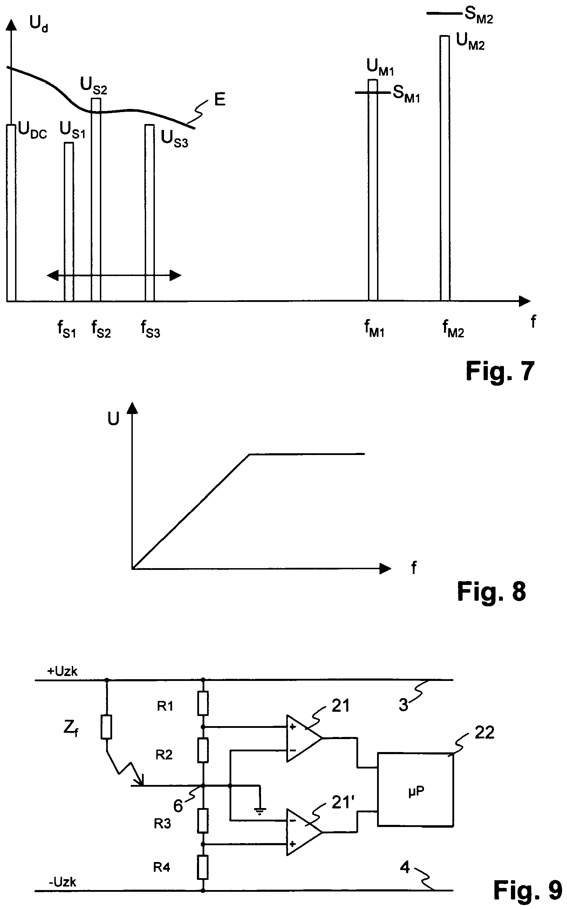

**Figur 7** zeigt ein Frequenzspektrum einer Differenzspannungsverlaufes. Schematisch sind eingezeichnet:
- U_{M1}, U_{M2}: Spektralanteile entsprechend einer ersten und einer zweiten Modulationsfrequenz f_{M1}, f_{M2};
- S_{M1}, S_{M2}: den Modulationsfrequenzen zugeordnete Referenzwerte;
- U_{S1}, U_{S2}, U_{S3}: Spektralanteile entsprechend unterschiedlichen Ausgangsfrequenzen f_{S1}, f_{S2}, f_{S3}, wobei eine Variabilität der Ausgangsfrequenzen durch einen Doppelpfeil angedeutet ist;
- E: eine Enveloppe von Referenzwerten für die Statorfrequenzen; und
- U_{DC}: ein Gleichsignalanteil der Differenzspannung.

Ein real gemessenes Spektrum weist weitere Frequenzanteile auf, die von beliebigen Störungen herrühren können und bei einer herkömmlichen Isolationsüberwachung die Ergebnisse verfälschen. Deshalb wird hier anhand der Informationen aus den einen oder mehreren Umrichtersteuerungen 9, 9', 9" das Differenzspannungssignal gefiltert, und es werden nebst dem Gleichsignalanteil U_{DC} vorzugsweise nur die Signalanteile im Bereich der Modulationsfrequenzen und/oder der Ausgangsfrequenzen betrachtet. Von diesen Signalanteilen ist bekannt, dass sie durch den oder die Umrichter erzeugt werden und deshalb einen Bezug zur Zwischenkreisspannung und zu den Isolationseigenschaften der angeschlossenen Geräte haben. Andere Spannungsfunktionen wie beispielsweise eine einzelne Teilspannung, ein Verhältnis von Teilspannungen, ein Verhältnis einer Teilspannung zur Gesamtspannung etc. weisen prinzipiell ähnliche Spektralanteile wie in der **Figur** 7 auf, und sind so in gleicher Weise durch eine solche Filterung gezielt analysierbar.

Modulationsfrequenzen liegen typischerweise im kHz Bereich, z.B. um 6 bis 8 kHz, Statorfrequenzen bei Antrieben liegen typischerweise zwischen Null und 1000 Hz. Zur Bestimmung der entsprechenden Signalanteile werden beispielsweise Bandpassfilter, vorzugsweise in Software realisiert, verwendet, deren Mittenfrequenz gleich der jeweiligen Statorfrequenz respektive Modulationsfrequenz ist. Die Modulationsfrequenzen und/oder Statorfrequenzen werden der Isolationsüberwachung 14 vorzugsweise durch die Umrichtersteuerung(en) 9 übermittelt, beispielsweise über einen Feldbus. Alternativ oder zusätzlich können diese Frequenzen bei einem, mehreren oder allen der Antriebe 11 durch Analyse der Zwischenkreisspannung(en) im Frequenzbereich ermittelt werden, beispielsweise durch eine FFT (Fast Fourier Transform), welche Signalanteile bei unterschiedlichen Frequenzen ermittelt. Damit kann auch in Echtzeit eine Signalanteil bei einer variierenden Frequenz verfolgt werden, und können seine Abweichungen von Referenzwerten bestimmt werden.

Die Referenzwerte S_{M1}, S_{M2}, E sind zudem individuell auf die eingesetzten Antriebe 11, 11', 11" ausgerichtet. Dazu werden anhand von theoretischen Vorgaben oder vorzugsweise in einer Lernphase oder "Teach-in"-Phase die Frequenzanteile eines Antriebs bei den im Betrieb vorgesehenen einer odere mehreren Modulationsfrequenzen und einer oder mehreren Ausgangsfrequenzen gemessen. Als Referenzwert wird jeweils ein um einen vorgegebenen Faktor höherer Wert gewählt. Bei Antrieben mit kontinuierlich variierenden Statorfrequenzen ergibt die Menge von separaten Referenzwerten die Referenzwertenveloppe E. Grundsätzlich kann jeder Antrieb eine eigene Referenzwertenveloppe E aufweisen, es kann aber zur Vereinfachung auch eine gemeinsame Referenzwertenveloppe E definiert sein.

Im Betrieb wird also für jeden der Antriebe 11, 11', 11" der Signalanteil bei seiner aktuellen Ausgangsfrequenz berechnet und in mit seiner Referenzwertenveloppe E verglichen. Wird diese überschritten, so wird ein Isolationsfehler angenommen. Dasselbe geschieht für die Signalanteile bei den Modulationsfrequenzen, wobei diese in der Regel unveränderlich sind. Beispielhaft ist bei f_{M1} ein Überschreiten des Referenzwertes S_{M1} eingezeichnet.

Es wird dabei berücksichtigt, dass zwei Antriebe beispielsweise vorübergehend dieselbe Statorfrequenz aufweisen können, oder permanent mit derselben Modulationsfrequenz arbeiten. Dabei überlagern sich ihre Signalanteile im Frequenzbereich. Deshalb hebt die Isolationsüberwachungsvorrichtung 14, falls zwei oder mehr der angeschlossenen Umrichtersteuerungen 9, 9', 9" dieselbe Statorfrequenz melden, den Referenzwert oder die Enveloppe bei dieser Frequenz an. Beispielsweise kann der Referenzwert auf die Summe der Referenzwerte für die beiden Antrieb bei dieser Frequenz angehoben werden. Andere mathematisch äquivalente Verfahren sind denkbar, das Grundprinzip bleibt, dass die Information über die Umrichterzustände bei der Beurteilung des Störspektrums berücksichtigt wird. Analoges gilt für die Modulationsfrequenzen und ist in der Figur beispielhaft mit dem vergleichsweise hohen Referenzwert S_{M2} bei f_{M2} eingezeichnet, wobei angenommen wird, dass zwei der in **Figur 7** repräsentierten drei Antriebe mit derselben Modulationsfrequenz f_{M2} arbeiten.

In einer weiteren bevorzugten Ausführungsform der Erfindung werden weitere Eigenschaften der Umrichtersteuerung 9 berücksichtigt, beispielsweise eine in der Antriebstechnik verwendete Beziehung zwischen Statorfrequenz und Statorspannung. **Figur 8** zeigt qualitativ eine übliche Frequenz-Spannungs-Kennlinie eines Antriebsumrichters. Frequenz und Spannung beziehen sich typischerweise auf die Frequenz und Spannungsamplitude der Grundschwingung der Statorspannung. Bei der Beurteilung des Signalspektrums wird mit berücksichtigt, dass in einem bestimmten Bereich die Statorspannung zusammen mit der Frequenz ansteigt. Deshalb wird vorzugsweise der Signalanteil bezüglich der Spannungsamplitude normiert oder skaliert (je nach Betrachtungsweise), beispielsweise durch Dividieren des Signalanteils vor oder nach der Filterung durch die Spannungsamplitude. Mathematisch im wesentliche äquivalente Methoden lassen sich auf die Signalenergie anwenden, oder durch Anheben von Referenzwerten proportional zur Spannungsamplitude.

**Figur 9** zeigt eine Messanordnung zur Messung von Zwischenkreisspannungen: Zwei Messverstärker 21, 21' verstärken die Spannung an Abgriffen von Spannungsteilerrn R1/R2 und R3/R4 zur Erfassung der oberen und der unteren Teilspannung. Ein Mikroprozessor 22, welcher mit der Datenverarbeitungseinheit 12 der Isolationsüberwachungsvorrichtung 14 identisch sein kann, bestimmt die Zwischenkreisspannung als Summe der Teilspannungen für beispielsweise die Umrichterregelung, und die Differenzspannung zur Isolationsüberwachung. Alternativ kann die Summierung oder Differenzbildung auch mit analogen Mitteln geschehen. Es ist ferner eine Fehlerimpedanz Zf eingezeichnet, welche veranschaulicht, dass sich die Symmetrie der Spannungen bei einem Isolationsfehler verschiebt. Solange die Leistungshalbleiter ausgeschaltet und keine Störungen im System vorhanden sind, kann also aus der Differenzspannung die Isolationsgüte des Zwischenkreises selbst bestimmt werden. Mögliche Isolationsfehler im Antrieb 11 oder in der Leitung 15 sind in diesem Zustand nicht sichtbar, weil die Leistungshalbleiter 1 nicht leiten.

In den beschriebenen Ausführungsformen ist die Erfindung anhand von Zweipunktumrichtern erläutert, sie ist aber sinngemäss genauso auf Dreipunktumrichter anwendbar.

### BEZUGSZEICHENLISTE

- 1a, 1b, 1c, 1a', 1b', 1c': Schalter
- 2a, 2b, 2c: Phasenanschlüsse
- 3: positiver Zweig
- 4: negativer Zweig
- 5, 5': Zweigspannungsmessung
- 6: Nullpunkt, Erde, PE oder Fahrzeugchassis
- 7: Zwischenkreis
- 8a, 8b, 8c: Strommesser
- 9, 9', 9": Umrichtersteuerung
- 10, 10', 10": Umrichter
- 11, 11', 11": Gerät, Antrieb
- 12: Datenverarbeitungseinheit
- 13: Kommunikationsanschluss
- 14: Isolationsüberwachungsvorrichtung
- 15: Leitung
- 21, 21': Messverstärker
- 22: Messwertverarbeitungseinheit, Mikroprozessor
- 31, 32, 33: Trajektorien von Differenzspannungen
- 61, 62: Differenzspannungsspitze

## Patentansprüche

1. Verfahren zur Isolationsüberwachung in einer Umrichteranwendung während eines Normalbetriebes der Umrichteranwendung, wobei die Umrichteranwendung aufweist:
- einen Spannungszwischenkreis (7) mit mindestens einem positiven Zweig (3) und einem negativen Zweig (4);
- mindestens ein elektrisches Gerät (11), welches mindestens zwei Phasenanschlüsse (2) aufweist; und
- mindestens einen Umrichter (10) mit Schaltelementen (1) zur elektrischen Verbindung der Phasenanschlüsse (2) mit dem positiven Zweig (3) oder dem negativen Zweig (4) des Spannungszwischenkreises (7);
und wobei das Verfahren die folgenden Schritte aufweist:
- Bestimmen eines Betriebszustandes des Umrichters (10) während dem der Umrichter (10) in Betrieb ist und das elektrische Gerät (11), welches dabei ebenfalls in einem Normalbetrieb ist, speist, durch Erfassen von Parametern einer Umrichtersteuerung (9);
- Messen von mindestens einer von
- einer Spannung des positiven Zweiges (3) und
- einer Spannung des negativen Zweiges (4); und
- Bestimmen von Isolationsdefekten am Spannungszwischenkreis (7) und/oder an den Phasenanschlüssen (2) und/oder am elektrischen Gerät (11) nach Maßgabe der gemessenen Spannung oder Spannungen und des Betriebszustandes des Umrichters, wobei das Verfahren durch die folgenden Schritte gekennzeichnet ist:
- Filtern einer Spannungsfunktion und Bestimmung von Signalanteilen der Spannungsfunktion in Frequenzbereichen entsprechend einer Ausgangsfrequenz oder einer Modulationsfrequenz des Umrichters, wobei die Spannungsfunktion eine Differenz von Teilspannungen der Zwischenkreisspannungen oder ein Verhältnis einer Teilspannung zur Gesamtspannung des Zwischenkreises oder eine einzelne Teilspannung ist; und
- Vergleich einer Amplitude der derart gefilterten Spannungsfunktion oder einer Gesamtenergie mehrerer derart gefilterter Spannungsfunktionen mit einem Referenzwert und, falls dieser Referenzwert überschritten wird, Annahme eines Isolationsfehlers.

2. Verfahren gemäß Anspruch 1, wobei die im Schritt des Bestimmens des Betriebszustandes des Umrichters (10) erfassten Parameter zumindest eine von Ausgangsfrequenz und Modulationsfrequenz des Umrichters umfassen.

3. Verfahren gemäß Anspruch 1 oder 2, wobei die im Schritt des Bestimmens des Betriebszustandes des Umrichters (10) erfassten Parameter zumindest eine von Ausgangsspannung und Ausgangsstrom des Umrichters (10) umfassen.

4. Verfahren gemäß einem der bisherigen Ansprüche, wobei beim Bestimmen eines Betriebszustandes des Umrichters (10) der folgende Schritt ausgeführt wird:
- eine Umrichtersteuerung (9) übermittelt zumindest eine von Ausgangsfrequenz und Modulationsfrequenz des Umrichters zur Isolationsüberwachung (14).

5. Verfahren gemäß einem der bisherigen Ansprüche, wobei beim Bestimmen eines Betriebszustandes des Umrichters (10) der folgende Schritt ausgeführt wird:
- Analysieren der Zwischenkreisspannung im Frequenzbereich und Ermitteln von zumindest einer von Ausgangsfrequenz und Modulationsfrequenz des Umrichters.

6. Verfahren gemäß einem der bisherigen Ansprüche, aufweisend den Schritt:
- Erfassen von gefilterten Signalen entsprechend den Ausgangsfrequenzen oder Modulationsfrequenzen von mehreren im Betrieb befindlichen Umrichtersteuerungen (9, 9' 9") und, falls mindestens zwei Umrichtersteuerungen (9, 9' 9") dieselbe Ausgangsfrequenz oder Modulationsfrequenz verwenden, Anheben von Referenzwerten bei dieser Frequenz.

7. Verfahren gemäß einem der bisherigen Ansprüche, aufweisend den Schritt:
- Skalieren der genannten Amplitude oder Energie nach Maßgabe einer Amplitude der Ausgangsspannung, bevor der Vergleich mit dem Referenzwert stattfindet.

8. Vorrichtung (14) zur Isolationsüberwachung für Umrichteranwendungen, wobei die Vorrichtung (14) zur Durchführung des Verfahrens nach einem der vorherigen Ansprüche ausgebildet ist, wobei die Umrichteranwendung aufweist:
einen Spannungszwischenkreis (7) mit mindestens einem positiven Zweig (3) und einem negativen Zweig (4);
- mindestens ein elektrisches Gerät (11) welches mindestens zwei Phasenanschlüsse (2) aufweist; und
- mindestens einen Umrichter (10) mit Schaltelementen (1) zur elektrischen Verbindung der Phasenanschlüsse (2) mit dem positiven Zweig (3) oder dem negativen Zweig (4) des Spannungszwischenkreises (7);
und wobei die Vorrichtung (14) aufweist:
- Mittel zum Bestimmen eines Betriebszustandes des Umrichters (10) in Form von mindestens einer Antriebsfrequenz oder einer Modulationsfrequenz des Umrichters (10);
- Messmittel zum Bestimmen von mindestens einer von
- einer Spannung des positiven Zweiges (3) und
- einer Spannung des negativen Zweiges (4);
- mindestens ein frequenzgesteuertes Filter zur Bestimmung von Signalanteilen in einer Spannungsfunktion, wobei die Spannungsfunktion eine Differenz von Teilspannungen der Zwischenkreisspannungen oder ein Verhältnis einer Teilspannung zur Gesamtspannung des Zwischenkreises oder eine einzelne Teilspannung ist, welches Filter dazu eingerichtet ist, Signalanteile im Bereich von mindestens einer Antriebsfrequenz oder einer Modulationsfrequenz des im Betrieb befindlichen Umrichters (10) zu bestimmen, und
- eine Datenverarbeitungseinheit (12) zum Bestimmen von Isolationsdefekten am Spannungszwischenkreis (7) und/oder an den Phasenanschlüssen (2) und/oder am elektrischen Gerät (11) durch Vergleichen einer Amplitude der derart gefilterten Spannungsfunktion oder einer Gesamtenergie mehrerer derart gefilterter Spannungsfunktionen mit einem Referenzwert und, falls dieser Referenzwert überschritten wird, Annahme eines Isolationsfehlers.

9. Vorrichtung (14) gemäß Anspruch 8, wobei die Zwischenkreisspannungsmessung zwei Teilspannungsmesseinrichtungen (5, 5') aufweist, welche eine erste Teilspannung zwischen dem positiven Zweig (3) und einem Nullpunkt (6) beziehungsweise eine zweite Teilspannung zwischen dem Nullpunkt (6) und dem negativen Zweig (4) messen.

10. Vorrichtung (14) gemäß Anspruch 8 oder 9, wobei die Vorrichtung (14) integraler Bestandteil einer Umrichtersteuerung (9) ist.

11. Vorrichtung (14) gemäß Anspruch 8 oder 9, wobei die Vorrichtung zur Bestimmung des Betriebszustandes mit einem Kommunikationsmittel (13) ausgestattet ist, welches Kommunikationsmittel (13) zum Empfang von Information zur Spezifizierung von mindestens der Antriebsfrequenz oder der Modulationsfrequenz einer Umrichtersteuerung (9) konfiguriert ist.

12. Verfahren zur Herstellung eines Überwachungsgerätes (9; 14) zur Isolationsüberwachung für Umrichteranwendungen, aufweisend die Schritte
- Bereitstellen einer Datenverarbeitungseinheit (12) und einer Speichereinheit des Überwachungsgerätes (9; 14), sowie von Messeingängen oder Kommunikationsmitteln zur Erfassung von Messwerten und deren Übermittlung an die Datenverarbeitungseinheit (12);
- Speichern eines Programmcodes in einer Speichereinheit des Überwachungsgerätes (14);
- wobei das Programmcode bei seiner Ausführung die Datenverarbeitungseinheit (12) zur Ausführung des Verfahrens gemäß einem der Ansprüche 1 bis 7 bringt.

## Claims

1. Method for insulation monitoring of an inverter application during a normal operation of the inverter application, wherein the inverter application comprises:
- an intermediate voltage circuit (7) with at least one positive branch (3) and a negative branch (4);
- at least one electrical apparatus (11) which comprises at least two phase connections (2); and
- at least one inverter (10) comprising switch elements (1) for the electrical connection of the phase connections (2) to the positive branch (3) or the negative branch (4) of the intermediate voltage circuit (7);
and wherein the method comprises the following steps:
- determining an operating condition of the inverter (10) while the inverter (10) is in operation and feeds the electrical apparatus (11) which likewise is in a normal operation by acquiring parameters of an inverter control (9);
- measuring at least one of
- a voltage of the positive branch (3) and
- a voltage of the negative branch (4);
- determining insulation defects at the intermediate voltage circuit (7) and/or at the phase connections (2) and/or at the electrical apparatus (11) in accordance with the measured voltage or voltages and the operating condition of the inverter,
wherein the method is **characterized by** the following steps:
- filtering a voltage function and determining signal proportions of the voltage function in frequency ranges corresponding to an output frequency or a modulation frequency of the inverter, wherein the voltage function is a difference of partial voltages of the intermediate circuit voltages, or a ratio of a partial voltage to the total voltage of the intermediate circuit, or an individual partial voltage; and
- comparing an amplitude of the voltage function filtered in such a manner, or a total energy of a plurality of voltage functions filtered in such a manner to a reference value, and, if this reference value is exceeded, signaling the presence of an insulation defect.

2. Method according to claim 1, wherein the parameters acquired in the step of determining the operating condition of the inverter (10) include at least one of an output frequency and a modulation frequency of the inverter.

3. Method according to claim 1 or 2, wherein the parameters acquired in the step of determining the operating condition of the inverter (10) include at least one of an output voltage and an output current of the inverter (10).

4. Method according to any of the preceding claims, wherein during determining an operating condition of the inverter (10), the following step is carried out:
- at least one of an output frequency and a modulation frequency of the inverter is transmitted to an insulation monitoring device (14) by an inverter control (9).

5. Method according to any of the preceding claims, wherein during determining an operating condition of the inverter (10), the following step is carried out:
- analyzing the intermediate circuit voltage in the frequency range and obtaining at least one of the output frequency and modulation frequency of the inverter.

6. Method according to any of the preceding claims, comprising the step:
- acquiring filtered signals corresponding to the output frequencies or modulation frequencies of multiple inverter controls (9, 9', 9") in operation, and, if at least two inverter controls (9, 9', 9") use the same output frequency or modulation frequency, raising reference values at this frequency.

7. Method according to any of the preceding claims, comprising the step:
- scaling said amplitude or energy in accordance with an amplitude of the output voltage, prior to comparing to the reference value.

8. Device (14) for insulation monitoring for inverter applications, wherein the device (14) is configured for performing the method according to any of the preceding claims, wherein the inverter application comprises:
- an intermediate voltage circuit (7) with at least one positive branch (3) and a negative branch (4);
- at least one electrical apparatus (11) which comprises at least two phase connections (2); and
- at least one inverter (10) with switch elements (1) for the electrical connection of the phase connections (2) to the positive branch (3) or the negative branch (4) of the intermediate voltage circuit (7);
and wherein the device (14) comprises:
- means for determining an operating condition of the inverter (10) in the form of at least one drive frequency or modulation frequency of the inverter (10);
- measuring means for determining at least one of
- a voltage of the positive branch (3) and
- a voltage of the negative branch (4);
- at least one frequency-controlled filter for determining signal proportions of a voltage function, wherein the voltage function is a difference of partial voltages of the intermediate circuit voltages, or a ratio of a partial voltage to the total voltage of the intermediate circuit, or an individual partial voltage, which filter is provided to determine signal proportions in the range of at least one drive frequency or modulation frequency of the inverter (10) in operation, and
- a data processing unit (12) for determining insulation defects at the intermediate voltage circuit (7) and/or at the phase connections (2) and/or at the electrical apparatus (11) by comparing an amplitude of the voltage function filtered in such a manner, or a total energy of a plurality of voltage functions filtered in such a manner to a reference value, and, if this reference value is exceeded, signaling the presence of an insulation defect.

9. Device (14) according to claim 8, wherein the intermediate circuit voltage measurement has two partial voltage measurement devices (5, 5'), which measure a first partial voltage between the positive branch (3) and a neutral point (6), or a second partial voltage between the neutral point (6) and the negative branch (4).

10. Device (14) according to claim 8 or 9, wherein the device (14) is an integral component of an inverter control (9).

11. Device (14) according to claim 8 or 9, wherein the device is provided with a communication means (13) for determining the operating condition, which communication means (13) is configured for receiving information for specification of at least the drive frequency or the modulation frequency of an inverter control (9).

12. Method for manufacturing a monitoring apparatus (9; 14) for insulation monitoring for inverter applications, comprising the steps:
- preparing a data processing unit (12) and a memory unit of the monitoring apparatus (9; 14), as well as measurement inputs or communication means for acquiring measured values and their transfer to the data processing unit (12);
- storing a program code in a memory unit of the monitoring apparatus (14);
- wherein the program code, with its implementation, causes the data processing unit (12) to carry out the method according to any of the claims 1 to 7.

## Revendications

1. Procédé de surveillance de l'isolation dans une application de convertisseur statique pendant un fonctionnement normal de l'application de convertisseur statique, l'application de convertisseur statique comprenant :
- un circuit intermédiaire de tension (7) pourvu d'au moins une branche positive (3) et une branche négative (4) ;
- au moins un appareil électrique (11) qui possède au moins deux bornes de phase (2) ; et
- au moins un convertisseur statique (10) pourvu d'éléments de commutation (1) servant à la connexion électrique des bornes de phase (2) à la branche positive (3) ou à la branche négative (4) du circuit intermédiaire de tension (7) ;
et le procédé comprenant les étapes suivantes :
- détermination d'un état de fonctionnement du convertisseur statique (10) pendant lequel le convertisseur statique (10) est en fonctionnement et alimente l'appareil électrique (11), lequel se trouve ici également dans un fonctionnement normal, par acquisition de paramètres d'une commande de convertisseur statique (9) ;
- mesure d'au moins l'une parmi
- une tension de la branche positive (3) et
- une tension de la branche négative (4) ; et
- détermination de défauts d'isolation au niveau du circuit intermédiaire de tension (7) et/ou au niveau des bornes de phase (2) et/ou au niveau de l'appareil électrique (11) en fonction de la tension ou des tensions mesurées et de l'état de fonctionnement du convertisseur statique,
le procédé étant **caractérisé par** les étapes suivantes :
- filtrage d'une fonction de tension et détermination de composantes de signal de la fonction de tension dans les plages de fréquences correspondant à une fréquence de sortie ou une fréquence de modulation du convertisseur statique, la fonction de tension étant une différence de tensions partielles des tensions du circuit intermédiaire ou un rapport entre une tension partielle et la tension totale du circuit intermédiaire ou une tension partielle individuelle ; et
- comparaison d'une amplitude de la fonction de tension ainsi filtrée ou d'une énergie totale de plusieurs fonctions de tension ainsi filtrées avec une valeur de référence et, dans le cas où cette valeur de référence est dépassée, supposition d'un défaut d'isolation.

2. Procédé selon la revendication 1, les paramètres acquis à l'étape de détermination de l'état de fonctionnement du convertisseur statique (10) comprenant la fréquence de sortie et/ou la fréquence de modulation du convertisseur statique.

3. Procédé selon la revendication 1 ou 2, les paramètres acquis à l'étape de détermination de l'état de fonctionnement du convertisseur statique (10) comprenant la tension de sortie et/ou le courant de sortie du convertisseur statique (10).

4. Procédé selon l'une des revendications précédentes, l'étape suivante étant exécutée lors de la détermination d'un état de fonctionnement du convertisseur statique (10) :
- une commande de convertisseur statique (9) communique au moins l'une parmi la fréquence de sortie et la fréquence de modulation du convertisseur statique en vue de la surveillance de l'isolation (14).

5. Procédé selon l'une des revendications précédentes, l'étape suivante étant exécutée lors de la détermination d'un état de fonctionnement du convertisseur statique (10) :
- analyse de la tension de circuit intermédiaire dans la plage de fréquences et identification de la fréquence de sortie et/ou la fréquence de modulation du convertisseur statique.

6. Procédé selon l'une des revendications précédentes, comprenant l'étape :
- acquisition de signaux filtrés conformément aux fréquences de sortie ou aux fréquences de modulation de plusieurs commandes de convertisseur statique (9, 9', 9") qui se trouvent en fonctionnement et, dans le cas où au moins deux commandes de convertisseur statique (9, 9', 9") utilisent la même fréquence de sortie ou fréquence de modulation, augmentation des valeurs de référence à cette fréquence.

7. Procédé selon l'une des revendications précédentes, comprenant l'étape :
- mise à l'échelle de ladite amplitude ou de l'énergie en fonction d'une amplitude de la tension de sortie avant que la comparaison avec la valeur de référence ait lieu.

8. Arrangement (14) de surveillance de l'isolation pour des applications de convertisseur statique, l'arrangement (14) étant configuré pour mettre en œuvre le procédé selon l'une des revendications précédentes, l'application de convertisseur statique comprenant :
- un circuit intermédiaire de tension (7) pourvu d'au moins une branche positive (3) et une branche négative (4) ;
- au moins un appareil électrique (11) qui possède au moins deux bornes de phase (2) ; et
- au moins un convertisseur statique (10) pourvu d'éléments de commutation (1) servant à la connexion électrique des bornes de phase (2) à la branche positive (3) ou à la branche négative (4) du circuit intermédiaire de tension (7) ;
et l'arrangement (14) possédant :
- des moyens pour déterminer un état de fonctionnement du convertisseur statique (10) sous la forme d'une fréquence d'excitation et/ou d'une fréquence de modulation du convertisseur statique (10) ;
- des moyens de mesure destinés à déterminer au moins l'une parmi
- une tension de la branche positive (3) et
- une tension de la branche négative (4) ;
- au moins un filtre commandé en fréquence destiné à déterminer des composantes de signal dans une fonction de tension, la fonction de tension étant une différence de tensions partielles des tensions du circuit intermédiaire ou un rapport entre une tension partielle et la tension totale du circuit intermédiaire ou une tension partielle individuelle, lequel filtre est conçu pour déterminer les composantes de signal dans la plage d'au moins une fréquence d'excitation ou une fréquence de modulation du convertisseur statique (10) qui se trouve en fonctionnement, et
- une unité de traitement de données (12) destinée à déterminer des défauts d'isolation au niveau du circuit intermédiaire de tension (7) et/ou au niveau des bornes de phase (2) et/ou au niveau de l'appareil électrique (11) par comparaison d'une amplitude de la fonction de tension ainsi filtrée ou d'une énergie totale de plusieurs fonctions de tension ainsi filtrées avec une valeur de référence et, dans le cas où cette valeur de référence est dépassée, supposer un défaut d'isolation.

9. Arrangement (14) selon la revendication 8, la mesure de la tension de circuit intermédiaire possédant deux dispositifs de mesure de tension partielle (5, 5') qui mesurent une première tension partielle entre la branche positive (3) et un point zéro (6) ou une deuxième tension partielle entre le point zéro (6) et la branche négative (4).

10. Arrangement (14) selon la revendication 8 ou 9, l'arrangement (14) faisant partie intégrante d'une commande de convertisseur statique (9).

11. Arrangement (14) selon la revendication 8 ou 9, l'arrangement étant équipé d'un moyen de communication (13) en vue de la détermination de l'état de fonctionnement, lequel moyen de communication (13) est configuré pour recevoir des informations destinées à spécifier au moins la fréquence d'excitation ou d'une fréquence de modulation d'une commande de convertisseur statique (9).

12. Procédé de fabrication d'un appareil de surveillance (9 ; 14) destiné à la surveillance de l'isolation pour des applications de convertisseur statique, comprenant les étapes suivantes
- fourniture d'une unité de traitement de données (12) et d'une unité de mémoire de l'appareil de surveillance (9 ; 14) ainsi que des entrées de mesure ou des moyens de communication servant à acquérir des valeurs mesurées et à les communiquer à l'unité de traitement de données (12) ;
- mémorisation d'un code de programme dans une unité de mémoire de l'appareil de surveillance (14) ;
- le code de programme, lors de son exécution dans l'unité de traitement de données (12), provoquant la mise en œuvre du procédé selon l'une des revendications 1 à 7.
